Europäisches Patentamt

European Patent Office

Office européen des brevets

(11) Publication number: **0 002 107**
A2

# (12) EUROPEAN PATENT APPLICATION

(21) Application number: 78300512.7

(22) Date of filing: 17.10.78

(51) Int. Cl.²: **H 01 L 21/18, H 01 L 29/78**

(30) Priority: 17.11.77 US 852452
17.11.77 US 852565

(43) Date of publication of application: 30.05.79
Bulletin 79/11

(84) Designated Contracting States: BE DE FR GB

(71) Applicant: RCA CORPORATION, 30 Rockefeller Plaza,
New York 10020 (US)

(72) Inventor: Weltzel, Charles Edward, 5921 E.
Thunderbird Road, Scottsdale Arizona (US)
Inventor: Scott, Joseph Hurlong, 630 Lake Drive,
Princeton New Jersey (US)

(74) Representative: Douglas, John Andrew et al, 50 Curzon
Street, LONDON, W1Y 8EU (GB)

(54) Planar semiconductor devices and method of making the same.

(57) A semiconductor device (10) includes a region (32) of polycrystalline silicon on a portion of the surface (13) of a body (12) of semiconductor material. A layer (26) of oxidized polycrystalline silicon is also on the semiconductor material body and extends to the polycrystalline silicon region. The surface of the silicon oxide layer is substantially coplanar with the surface of the polycrystalline silicon region so that a metal film conductor (28) can be easily provided over the semiconductor device. The polycrystalline silicon region may be the gate of an MOS transistor or a conductive region of any type of semiconductor device. The semiconductor device is made by forming a polycrystalline silicon layer over the semiconductor material body, forming a mask on a portion of the polycrystalline silicon layer, reducing the thickness of the unmasked portion of the polycrystalline silicon layer and then oxidizing the unmasked portion of the polycrystalline silicon layer to form the oxide layer.

In MOS transistors, both the contacts and gate of the device can be formed from one polycrystalline silicon layer by appropriate masking, thinning, and oxidizing steps.

ACTORUM AG

PLANAR SEMICONDUCTOR DEVICES

AND METHOD OF MAKING THE SAME

The present invention relates to a semiconductor device having a substantially planar surface and particularly to such a semiconductor device which includes at least one region of polycrystalline silicon on a body of semiconductor material.

In many semiconductor devices, particularly integrated circuit devices, it is desirable that the device have a planar surface over which extends the metallization forming contacts to portions of the device and interconnections between the contacts. This planar surface is desirable so that the metallization does not have to extend over edges which can cause breaks in the metallization. Also, it is easier to define a metallization pattern which is substantially planar.

This problem of providing a planar surface is most apparent in silicon-on-sapphire (SOS) semiconductor devices which include a plurality of individual bodies or islands of semiconductor material in spaced relation on a substrate of insulating material, such as sapphire. The spaced bodies of the semiconductor material form ridges over which the metallization must be extended.

However, various techniques have been developed to fill in the spaces between the spaced bodies of the semiconductor material with an insulating material so as to provide a planar surface over which the semiconductor surface can extend.

A type of semiconductor device often used in integrated circuit devices and particularly SOS integrated circuit devices is the MOS transistor which includes a gate over the semiconductor material body. One type of gate used is made of polycrystalline silicon which is relatively thick and thus provides a ridge over which metallization must extend. Therefore it would be desirable to have such a semiconductor device which includes a polycrystalline silicon gate with a substantially planar surface over which the metallization can extend.

Heretofore MOS transistors having a conductive silicon gate and conductive silicon source and drain contacts have been formed by depositing a layer of polycrystalline silicon over an oxide layer on a body of semiconductor material. The oxide layer has one or more openings therethrough through which the polycrystalline silicon layer extends to contact the semiconductor body. A masking layer is formed over the portions of the polycrystalline silicon layer which are to form the gate and the source and drain contacts. The unmasked portions of the polycrystalline silicon layer are then removed with a suitable etchant to define the polycrystalline silicon layer into the gate, source and drain contacts. This technique is described in U.S. Patent No. 4,016,587 to De La Moneda, issued on April 5, 1977, and U.S. Patent No. 3,942,241 to Harigaya et al, issued on March 9, 1976.

One problem with this technique is that the semiconductor body is generally of single crystalline silicon which is etched by the same etchant generally used to etch the polycrystalline silicon. Thus, unless the etching of the polycrystalline silicon layer is controlled very closely the etching may extend into the semiconductor body and thereby adversely affect the transistor being made. This can be a greater problem if the transistor is a silicon-on-sapphire device in which the semiconductor body is a relatively thin epitaxial layer of single crystalline silicon. Any over etching of the polycrystalline silicon layer would remove a portion of the semiconductor body.

Another problem with this technique for making a MOS transistor is that the completed device generally has an uneven or nonplanar surface. If the device requires a metallization pattern to make electrical connections to the device, the metallization pattern would have to extend over the edges of the uneven surfaces, which could cause breaks in the metallization pattern. Also, it is relatively difficult to define a metallization pattern on an uneven surface.

A semiconductor device includes a body of semiconductor material having a region of polycrystalline silicon over a portion of the semiconductor body. A layer of oxidized polycrystalline silicon is over the semiconductor body and extends up to and contacts the polycrystalline silicon region. The surface of the oxidized polycrystalline silicon layer is substantially coplanar with the surface of the polycrystalline silicon region. The device is made by depositing a layer of polycrystalline silicon over the semiconductor body, forming a mask over a portion of the polycrystalline silicon layer, reducing the thickness of the unmasked portion of the polycrystalline silicon layer and oxidizing the unmasked portion of the polycrystalline silicon layer to form the silicon oxide layer.

In the drawings:-

FIG. 1 is a sectional view of an MOS transistor made in accordance with the present invention.

FIGS. 2-4 are sectional views illustrating the various steps of making the transistor shown in FIG. 1.

FIG. 5 is a sectional view of an MOS transistor embodying the present invention.

FIGS. 6-8 are sectional views illustrating the steps of making the transistor shown in FIG.5.

FIG. 9 is a sectional view of another form of MOS transistor embodying the present invention.

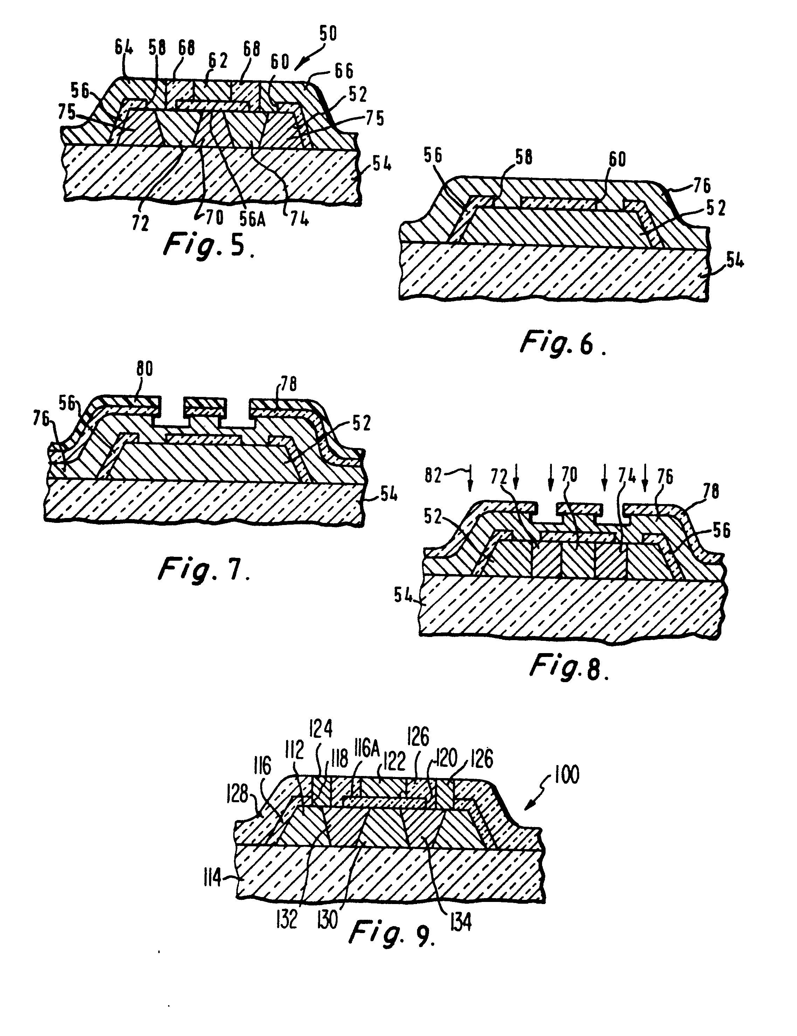

Referring initially to FIG. 5, one form of MOS transistor made in accordance with the present invention is generally designated as 10. The MOS transistor 10 comprises a body 12 of a semiconductor material, such as single crystalline silicon, on a substrate 14 of insulating material, such as sapphire. The semiconductor body 12 has a planar surface 13 includes a middle portion 16 of one conductivity type which serves as the channel of the transistor, and end portions 18 and 20 of the opposite conductivity type which serve as the source and drain regions of the transistor. A thin layer 22 of an oxide, such as silicon oxide is on and covers the planar surface 13 of the semiconductor body 12. The portion of the silicon oxide layer 22 which extends over the channel region 16 serves as the channel oxide of the transistor 10. A region 24 of polycrystalline silicon is on the silicon oxide layer 22 and extends over the channel region 16 of the semiconductor body 12. The polycrystalline silicon region 24 serves as the gate of the transistor and may include a conductivity modifier to increase the conductivity of the region. Also, the polycrystalline silicon region 24 is relatively thick, typically around 5000$^\circ$A as compared to the channel oxide layer 22, which is typically about 1000$^\circ$A. A layer 26 of oxidized polycrystalline silicon is on the remaining portion of the channel oxide layer 22 and extends up to and contacts the polycrystalline silicon region 24. The surface of the oxidized polycrystalline silicon layer 26 is substantially coplanar with the surface of the polycrystalline silicon region 24 so as to provide a planar surface over which metallization can extend. Metal contacts 28 and 30 extend through openings in the oxidized polycrystalline silicon layer 26 and the silicon oxide layer 22 to contact the source and drain regions 18 and 20, respectively.

To make the MOS transistor 10, a body 12 of the semiconductor material is first formed on the substrate 14 in a manner well known in the art of making a silicon-on-sapphire device. The semiconductor material body 12 is generally a portion of a layer of the semiconductor material epitaxially grown on the substrate 14. The semiconductor body 12 is initially of the conductivity type desired for the channel region 16. The silicon oxide layer 22 is then formed, such as by heating the semiconductor material body 12 in an oxidizing ambient to a temperature of about $1000^\circ$C for a time long enough to grow the silicon oxide layer to the desired thickness, which is about $1000^\circ$A.

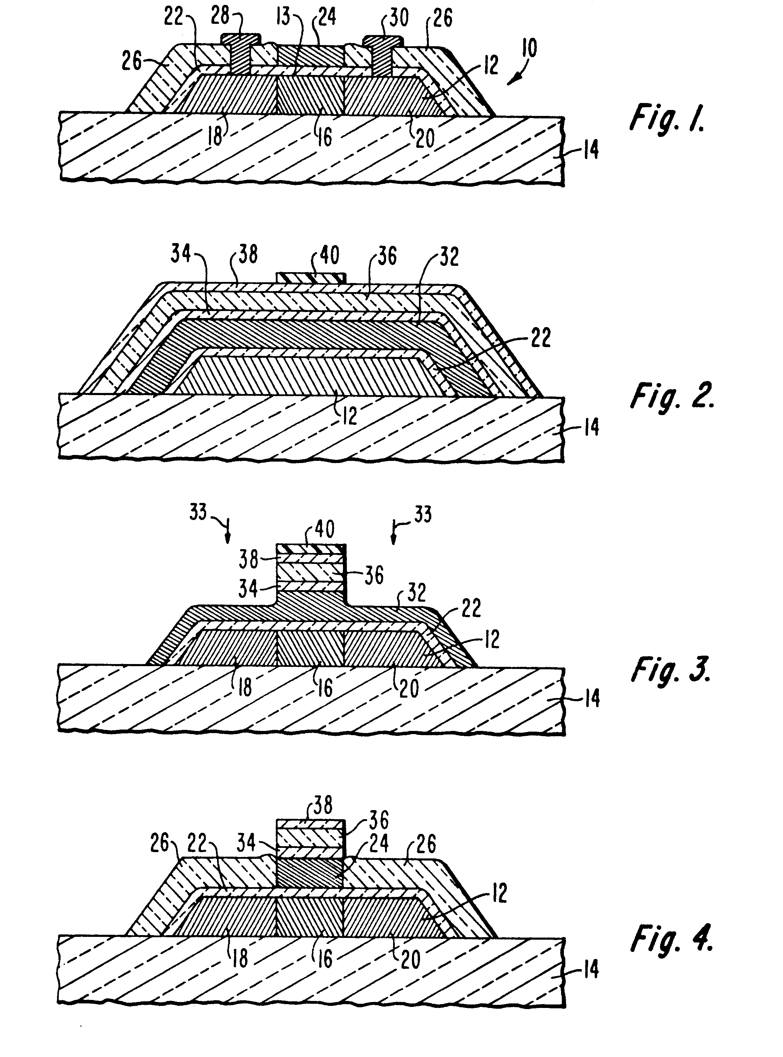

Next a layer 32 of polycrystalline silicon is deposited over the silicon oxide layer 22 as shown in FIG. 2. The polycrystalline silicon layer may be deposited by pyrolytically decomposing a material containing silicon, such as silane ($SiH_4$). Next, a very thin layer 34, approximately $100-200^\circ$A in thickness of silicon oxide is formed over the polycrystalline silicon layer 32. This may be formed by either heating the polycrystalline silicon layer 32 in an oxidizing atmosphere or by pyrolytically decomposing a material containing silicon in an oxygen ambient.

A masking layer 36 of silicon nitride is then deposited over the silicon oxide layer 34. This can be accomplished by pyrolytically decomposing silane and ammonia at a temperature of about $750^\circ$C. The silicon nitride layer 36 is typically of a thickness of between 500 and $2000^\circ$A. A layer 38 of silicon oxide is then provided over the silicon nitride layer 36. The silicon oxide layer 38 may be formed by pyrolytically decomposing a material containing silicon, such as silane, in an oxidizing ambient. The silicon oxide layer 38 may be of a thickness of about $500^\circ$A. A layer 40 of photoresist material is then provided on the silicon oxide layer 38 over the region of the semiconductor body 12 which is to form the channel region 16. The photoresist layer 40 is formed by standard photolithographic techniques.

As shown in FIG.3, the unmasked portion of the silicon oxide layer 38 is first removed, such as by etching with buffered hydrofluoric acid, to expose the silicon nitride layer 36 which is then removed, such as by etching with phosphoric acid. This exposes the silicon oxide layer 34 which is then removed with buffered hydrofluoric acid to expose the polycystalline silicon layer 32. The exposed portions of polycrystalline silicon layer 32 are then reduced in thickness, such as by etching with potassium hydroxide at $75^{\circ}$C. The exposed portions of the polycrystalline silicon layer 32 are reduced in thickness by about one-half. Instead of using various etchants to remove the exposed portions of various layers, they can be removed by plasma etching if desired.

The source and drain regions 18 and 20 of the transistors are then formed by ion implanting conductivity modifiers into the semiconductor body 12 through the thinned portions of the polycrystalline silicon layer 32 as indicated by the arrows 33 in FIG. 3. With a polycrystalline silicon layer 32 thinned down to about 2500-$3000^{\circ}$A and a channel oxide layer of about $1000^{\circ}$A, phosphorus ions for inducing N type conductivity, can be implanted into the semiconductor body 12 at 300 KeV and a dosage of $2 \times 10^{15}$ ions/square centimeter. Boron ions for inducing P type conductivity can be implanted at 110 KeV at a dosage of $2 \times 10^{15}$ ions/square centimeter.

The device is then heated in a oxygen ambient at a temperature of about $950^{\circ}$C to oxidize the thinned down portion of the polycrystalline silicon layer 32 which is not covered by the various masking layers. As the polycrystalline silicon layer is oxidized it increases in thickness. It is known that when a layer of silicon is oxidized it will about double in thickness. Thus, when the thinned down portion of the polycrystalline silicon layer is completely oxidized it will have a thickness substantially equal to the thickness of the masked portion of the polycrystalline silicon layer which is not oxidized. Thus when the thinned down portion of the polycrystalline silicon layer 32 is completely oxidized, there will be provided the polycrystalline silicon region 24 over the channel region 16 and the oxidized polycrystalline silicon layer 26 on each side of the polycrystalline silicon region 24, with the surface of the oxidized polycrystalline silicon layer 26 being substantially coplanar with the surface of the polycrystalline silicon region 24.

The masking layer 38 of silicon oxide, the silicon nitride layer 36 and the silicon oxide layer 34 can then be removed with suitable etchants. Finally, openings can be formed in the oxidized polycrystalline silicon layer 20 and the channel oxide layer 22 and the metal contacts 28 and 30 (FIG. 1) formed in such openings. When the masking silicon oxide layers 38 and 34 are removed, the etchant may also remove some of the oxidized polycrystalline silicon layer 26. Therefore, it is preferable to form the oxidized polycrystalline silicon layer slightly thicker than the polycrystalline silicon region 24 so that after the masking oxide layers are removed the surface of the oxidized polycrystalline silicon layer 26 will be coplanar with the surface of the polycrystalline silicon region 24.

Thus there is provided a semiconductor device, particularly a MOS transistor, having a relatively thick region of polycrystalline silicon, with the surface of

0002107

the device being made planar by an oxidized polycrystalline silicon layer extending up to the polycrystalline silicon region and having a surface which is substantially coplanar with the surface of the polycrystalline silicon region. Although the present invention has been described with regard to making a single MOS transistor, it can also be used in an integrated circuit having a plurality of spaced bodies of semiconductor material on an insulating substrate with a separate MOS transistor in each body. Also, although the present invention has been described with regard to an MOS transistor made in silicon body on an insulating substrate (silicon-on-sapphire), the invention can also be used for an MOS device or devices in a bulk body of semiconductor material.

Referring now to FIG. 5, another form of MOS transistor embodying the present invention is generally designated as 50. The transistor 10 comprises a body 52 of semiconductor material, such as single crystalline silicon, on a substrate 54 of an electrical insulating material, such as sapphire. A layer 56 of an oxide is on the surface of the semiconductor body 52. If the semiconductor body 52 is of silicon, the oxide layer 56 is preferably of silicon dioxide. The oxide layer 56 has a pair of spaced openings 58 and 60 therethrough to the surface of the semiconductor body 52. The portion 56A of oxide layer 56 between the openings 58 and 60 serves as the channel oxide of the transistor 50. A region 62 of conductive polycrystalline silicon is on the channel oxide portion 56A of the oxide layer and is spaced from the openings 58 and 60. The polycrystalline silicon region 62 serves as the gate of the transistor 50.

Separate conductive polycrystalline silicon regions 64 and 66 extend through the openings 58 and 60, respectively, in the oxide layer 56 and contact the surface of the semiconductor body 52. The polycrystalline silicon regions 64 and 66 fill only a portion of their respective openings 58 and 60 and are spaced from the gate region 62. The polycrystalline silicon regions 64 and 66 serve as contacts for the source and drain of the transistor 50. As shown, the contact regions 64 and 66 extend over the oxide layer 56 away from the gate region 62. Between the gate 62 and each of the contact regions 64 and 66 is a layer 68 of oxidized polycrystalline silicon. The oxidized polycrystalline silicon layers 68 completely fill the spaces between the gate region 62 and the contact regions 64 and 66, including the portions of openings 58 and 60 not filled by the contact regions. The top surfaces of the gate region 62, contact regions 64 and 66 and the oxidized polycrystalline silicon layers 68 are all substantially coplanar.

The semiconductor body 52 has a channel region 70 of one conductivity type directly beneath the gate 62. Source and drain regions 72 and 74 of a conductivity type opposite to that of the channel region 70 are on opposite sides of the channel region. At the surface of the semiconductor body 52 the source and drain regions 72 and 74 are of a width to extend across at least a portion of the contact regions 64 and 66 so that the contact regions 64 and 66 are electrically connected to the source and drain regions 72 and 74, respectively. As shown, the semiconductor body 52 has end regions 75 between the source and drain region 72 and 74 and the edges of the semiconductor body 52 which are of the same conductivity type as the channel region 70.

To make the MOS transistor 50, a body 52 (FIG. 6) of semiconductor material is first formed on the substrate 54 in a manner well known in the art of making a silicon-on-sapphire device. The semiconductor material body 52 is generally a portion of a layer of semiconductor material epitaxially grown on the substrate 54 and is initially of the conductivity type desired for the channel region 70. The material of the semiconductor body can either be grown of the desired conductivity type or can be modified to the desired conductivity after being grown either by diffusion or ion implantation. The oxide layer 56, which is generally silicon dioxide when the semiconductor material is silicon, is then formed on the semiconductor body 52, such as by heating the semiconductor body 52 in an oxidizing ambient at a temperature of about $1000^{\circ}$C. The openings 58 and 60 are then formed in the oxide layer 56 by masking the oxide layer with a photoresist, except where the openings are to be formed, using a standard photolithographic technique. The areas of the oxide layer not covered with the photoresist are then removed, generally with a suitable etchant. For an oxide layer of silicon dioxide, buffered hydrofluoric can be used to etch the openings 58 and 60.

As shown in FIG. 6, next a layer 76 of polycrystalline silicon is deposited over the oxide layer 56 and in the openings 58 and 60 so as to contact the surfaces of the semiconductor body 52. The polycrystalline silicon layer may be deposited by pyrolytically decomposing a material containing silicon (such as silane $SiH_4$). The deposition of the polycrystalline silicon layer 76 is preferably carried out at a temperature below $900^{\circ}C$. However, if the deposition is carried out at a temperature about $940^{\circ}C$, the portions of the polycrystalline silicon layer 76 which are formed in the openings 58 and 60 will be single crystalline silicon epitaxially grown on the surface portions of the semiconductor body 52. For the purpose of the present invention, the polycrystalline silicon layer 76 may be entirely of polycrystalline silicon or may have portions which are in the openings 58 and 60 of single crystalline silicon.

As shown in FIG. 7, a masking layer 78 is then coated over the polycrystalline silicon layer 76. The masking layer 78 is at least partially of a material which is not etched by an etchant for removing the polycrystalline silicon layer 76. Silicon nitride is a suitable material for the masking layer 78. A masking layer of silicon nitride can be deposited by pyrolytically decomposing silane and ammonia at a temperature of about $750^{\circ}C$. Since it will be necessary to provide openings in the masking layer 78, it is preferable to coat the silicon nitride masking layer with a material such as silicon dioxide, which can be used as a mask for etching silicon nitride. Also, to provide a good adherence of the masking layer 78 to the polycrystalline silicon layer 76, it is preferable to first coat the polycrystalline silicon layer with a thin layer of silicon dioxide to which the silicon nitride masking layer will have good adherence. Thus the masking layer 78 is preferably a multi-material layer, having a first thin layer of silicon dioxide directly on the polycrystalline silicon layer 76, then a layer of silicon nitride, and finally an outer layer of silicon dioxide. The silicon dioxide layer directly on the polycrystalline silicon layer 76 may be formed by either heating the polycrystalline silicon layer in an oxidizing ambient or by pyrolytically decomposing a material containing silicon in an oxygen ambient. The silicon dioxide outer layer may be formed by pyrolytically decomposing a material containing silicon, such as silane, in an oxidizing ambient.

A layer 80 of a photoresist material is then formed over the portions of the masking layer 78 which are over the portions of the polycrystalline silicon layer 76 which are to form the gate region 62 and contact regions 64 and 66. The portions of the masking layer 78 which are not coated with the photoresist layer 80 are then removed with suitable etchants. Each of the silicon dioxide layers of the masking layer 78 can be removed with buffered hydrofluoric acid and the portions of the silicon nitride layer can be removed with phosphoric acid.

Removing the portions of the masking layer 78 exposes portions of the surface of the polycrystalline silicon layer 76. These exposed portions of the polycrystalline silicon layer 76 are then reduced in thickness such as by etching with potassium hydroxide at $72^{\circ}C$. The exposed portions of the polycrystalline silicon layer 76 are reduced in thickness by about one-half.

The source and drain regions 72 and 74 of the transistor are then formed by ion implanting conductivity modifiers in the semiconductor body 52 through the thin portions of the polycrystalline silicon layer 76, as indicated by the arrows 82 in FIG. 8. With a polycrystalline silicon 76 thinned down to about 2500-3000°A and a channel oxide layer 56A of about 1000°A, phosphorus ions for inducing N type conductivity can be implanted into the semiconductor body 12 at 300 KeV and a dosage of $2 \times 10^{15}$ ions/square centimeter. Boron ions for inducing P type ions can be implanted at 110 KeV at a dosage of $2 \times 10^{15}$ ions/square centimeter. At the same time that the ions are implanted in the semiconductor body 52 to form the source and drain regions 72 and 74 the ions are also implanted in the thicker portions of the polycrystalline silicon layer 76 through the masking layer 78 so as to increase the conductivity of the thicker portions which are to form the gate region 62 and the contact regions 64 and 66.

The device is then heated in an oxygen ambient at a temperature of about 950°C to oxidize the thinned down portions of the polycrystalline silicon layer 76 which are not covered by the masking layer 78. As the polycrystalline silicon layer is oxidized, it increases in thickness. It is known that when a layer of silicon is oxidized it will about double in thickness. Thus, when the thinned down portion of the polycrystalline silicon layer is completely oxidized it will have a thickness substantially equal to the thickness of the masked portions of the polycrystalline silicon layer which are not oxidized. When the thinned down portion of the polycrystalline silicon layer 76 is completely oxidized there will be provided the polycrystalline silicon gate region 62 over the channel region 56A, the polycrystalline silicon contact regions 64 and 66 and the oxidized polycrystalline silicion layers 68 between the gate region and each of the contact regions. The surfaces of the oxidized polycrystalline silicon layers 68 will be substantially coplanar with the surfaces of the gate region 62 and contact regions 64 and 66. The heating of the devices during the oxidation of the polycrystalline silicon layer will also cause lateral movement of the ions implanted in the source and drain regions 72 and 74 so as to expand the source and drain regions over and into contact with the polycrystalline silicon contact regions 64 and 66. However, the device is preferably annealed at 1050°C in an inert atmosphere to insure that the implanted ions move laterally.

Finally, the masking layer 78 can be removed with suitable etchants for each layer thereof. However, when the silicon dioxide layers of the masking layer 78 are removed, the etchant may also remove some of the oxidized polycrystalline silicon layer 68. Therefore it is preferable to form the oxidized polycrystalline silicon layers 68 slightly thicker than the polycrystalline silicon gate region 62 and contact regions 64 and 66 so that after the masking layer 78 is completely removed the surface of the oxidized polycrystalline silicon layers 68 will be coplanar with the surface of the gate and contact regions.

Referring to FIG. 9, there is shown a modification of the MOS transistor 50 which is generally designated as 100. The MOS transistor 100 is similar in structure to the MOS transistor 50 shown in FIG. 5 in that it includes a body 112 of semiconductor material on a substrate 114 of an electrical insulating material, an oxide layer 116 on the surface of the semiconductor body 112 with the oxide layer having a pair of spaced openings 118 and 120 therethrough. A gate region 122 of polycrystalline silicon is on the portion 116A of the oxide layer between the openings 118 and 120. Contact regions 124 and 126 of conductive polycrystalline silicon are in the openings 118 and 120 respectively and contact the surface of the semiconductor body 112. Between the gate region 122 and each of the contact regions 124 and 126 is a layer 128 of oxidized polycrystalline silicon, the surface of which is substantially coplanar with the surface of the gate and contact regions. The contact regions 124 and 126 differ from the contact regions 64 and 66 of the MOS transistor 50 in that they are limited in area to the openings 118 and 120. In the MOS transistor 100 the layers 128 of oxidized polycrystalline silicon extend over the portions of the oxide layer 116 which cover the end portions of the semiconductor body 112.

The semiconductor body includes a channel region 130 of one conductivity type beneath the gate region 122 and source and drain regions 132 and 134 at opposite sides of the channel region of a conductivity type opposite to that of the channel region. The source and drain regions 132 and 134 extend beneath the source and drain contacts 124 and 126.

The MOS transistor 100 is made in the same manner as previously described with regard to the MOS transistor 50, except that the masking layer is provided over a smaller portion of the polycrystalline silicon layer so as to form the smaller contact regions 124 and 126. The portions of the polycrystalline silicon layer over the N portions of the semiconductor body 112 are reduced in thickness and oxidized to form the oxidized polycrystalline silicon layers 128.

Thus, there is provided by the present invention an MOS transistor in which the conductive gate and contact regions are defined without an etching operation which could damage the semiconductor body. Also, the MOS transistor has a surface which is substantially planar so as to permit ease of forming any metallization pattern on the transistor. Although the MOS transistor has been described as being formed in a body of semiconductor material on an insulating substrate such as used in silicon-on-sapphire devices, the MOS transistor may be formed in a bulk body of the semiconductor material.

CLAIMS

1.  A method of making a semiconductor device (10, 50, or 100), including a step of depositing a layer (32, 76) of polycrystalline silicon over the surface (13, , ) of a body (12, 52, 112) of semiconductor material, forming a mask (36 78, ) over a portion of the polycrystalline silicon layer (32, 76 ), and oxidizing the unmasked portion of the polycrystalline silicon layer (32, 76, ), said method being characterized by prior to the oxidizing step reducing the thickness of the unmasked portion of the polycrystalline silicon layer (32, 76, ), and carrying out the oxidizing step to form a silicon oxide layer (26, 68, 128) adjacent the masked portion of the polycrystalline silicon layer (32, 76, ) which has a surface substantially coplanar with the surface of the masked portion of the polycrystalline silicon layer (32, 76).

2.  The method in accordance with Claim 1 characterized in that the unmasked portion of the polycrystalline silicon layer (32, 76, ) is reduced in thickness to about one-half the original thickness of the polycrystalline silicon layer (32, 76,).

3.  The method in accordance with Claim 2 in which the semiconductor device (10, 50, or 100) is an MOS transistor and the semiconductor body (12, 52 112) is initially of one conductivity type, characterized by the further steps of: providing a channel oxide layer (22, 56A, 116A) on the surface (13, , ) of the semiconductor body prior to depositing the polycrystalline silicon layer (32, 76, ), and, after the unmasked portion of the polycrystalline silicon layer (32, 76, ) is reduced in thickness and before the oxidation step, implanting into the semiconductor body (12, 52, 112 ) on each side of the mask ions of a conductivity modifier of the type opposite to that of the initial conductivity type of the semiconductor body (12, 52, 112).

4. The method in accordance with Claim 1 characterized in that said layer (76, ) of polycrystalline silicon is deposited over an oxide layer (56, 116) on said body (52, 112) of semiconductor material and into an opening (58, 60, 118 or 120) in the oxide layer (56, 116) so that the polycrystalline silicon contacts the surface of the semiconductor body (52, 112), and said mask (78, ) is patterned so that there is a mask component over a portion of the polycrystalline silicon layer (76, ) which is spaced from the opening (58, 60, 118 or 120) in the oxide layer (56, 116), and a separate mask component over the portion of the polycrystalline silicon layer (76, ) which extends into a portion of the opening (58, 60, 118 or 120), said mask components being spaced from each other.

5. A semiconductor device comprising:
a body (12, 52, 112) of semiconductor material,
a region (24, 62, 122) of polycrystalline silicon over a portion of the semiconductor body (12, 52, 112), and
a layer (26, 68, 128) of oxidized polycrystalline silicon over the semiconductor body (12, 52, 112), said oxidized polycrystalline silicon layer (26, 68, 128) extending up to and contacting the polycrystalline silicon region (24, 62, 122), characterized in that the surface of the oxidized polycrystalline silicon layer (26, 68, 128) is substantially coplanar with the surface of the polycrystalline silicon region (24, 62, 122).

6. A semiconductor device in accordance with Claim 5 characterized further in that at least a portion of the surface of the semiconductor body (12, 52, 112) is planar and the polycrystalline silicon region (24, 62, 122) and at least portions of the surface of the oxidized polycrystalline silicon layer (26, 68, 128) adjacent the polycrystalline silicon region (24, 62, 122) are over the planar surface of the semiconductor body (12, 52, 112).

7. A semiconductor device in accordance with Claim 5 in which the body (52, 112) of semiconductor material has a surface, with a layer (56, 116) of an oxide over the surface, said oxide layer (56, 116) having an opening (58, 60, 118 or 120) therethrough to the surface of the semiconductor body (52, 112), one polycrystalline silicon region (62, 122) being on the oxide layer (56, 116) at a location spaced from the opening (58, 60, 118 or 120), another polycrystalline silicon region (64, 66, 124 or 126) being on the oxide layer (56, 116) and extending into the opening (58, 60, 118 or 120) to contact the surface of the semiconductor body (52, 112), the oxidized polycrystalline silicon (68, 128) extending up to and contacting both regions (62, 122 and 64, 66, 124 or 126) of polycrystalline silicon, said device being further characterized in that the surface of the oxidized polycrystalline silicon (68, 128) is substantially coplanar with the surfaces of both the regions (62, 122 and 64, 66, 124 or 126) of polycrystalline silicon.

*Fig. 1.*

*Fig. 2.*

*Fig. 3.*

*Fig. 4.*

Fig. 5.

Fig. 6.

Fig. 7.

Fig. 8.

Fig. 9.